(19) Europäisches Patentamt
European Patent Office
Office européen des brevets

(11) **EP 2 311 101 B1**

(12) **EUROPEAN PATENT SPECIFICATION**

(45) Date of publication and mention of the grant of the patent:
**21.11.2012 Bulletin 2012/47**

(51) Int Cl.:
*H01L 31/02* [(2006.01)]     *H01L 31/042* [(2006.01)]
*H01L 27/30* [(2006.01)]     *H01L 51/44* [(2006.01)]

(21) Application number: **09772555.0**

(22) Date of filing: **03.07.2009**

(86) International application number:
**PCT/EP2009/058456**

(87) International publication number:
**WO 2010/000855 (07.01.2010 Gazette 2010/01)**

(54) **PHOTOVOLTAIC MODULE AND THE PROCESSING THEREOF**

FOTOVOLTAIKMODUL UND DESSEN HERSTELLUNG

MODULE PHOTOVOLTAÏQUE ET PROCÉDÉ POUR SA FABRICATION

(84) Designated Contracting States:
**AT BE BG CH CY CZ DE DK EE ES FI FR GB GR HR HU IE IS IT LI LT LU LV MC MK MT NL NO PL PT RO SE SI SK SM TR**

(30) Priority: **03.07.2008 US 78286**

(43) Date of publication of application:
**20.04.2011 Bulletin 2011/16**

(73) Proprietor: **IMEC**
**3001 Leuven (BE)**

(72) Inventors:
• **AERNOUTS, Tom**
  **B-2235 Westmeerbeek (BE)**
• **POORTMANS, Jef**
  **B-3010 Kessel-Lo (BE)**

(74) Representative: **pronovem**
**Office Van Malderen**
**Avenue Josse Goffin 158**
**1082 Bruxelles (BE)**

(56) References cited:
**US-A- 4 784 701**     **US-A- 4 847 669**
**US-A1- 2005 217 717**     **US-A1- 2007 169 816**
**US-A1- 2007 272 918**

• **MUTOLO K L ET AL: "Enhanced Open-Circuit Voltage in Subphthalocyanine / C60 Organic Photovoltaic Cells" JOURNAL OF THE AMERICAN CHEMICAL SOCIETY, AMERICAN CHEMICAL SOCIETY, NEW YORK, USA, vol. 128, 2 June 2006 (2006-06-02), pages 8108-8109, XP002465887 ISSN: 0002-7863**
• **SHROTRIYA VISHAL ET AL: "Transition metal oxides as the buffer layer for polymer photovoltaic cells" APPLIED PHYSICS LETTERS, AIP, AMERICAN INSTITUTE OF PHYSICS, MELVILLE, NY, US, vol. 88, no. 7, 16 February 2006 (2006-02-16), pages 73508-073508, XP012082917 ISSN: 0003-6951**

**Description**

**Field of the Invention**

This invention relates to multi-junction photovoltaic modules and to methods for fabricating such modules.
More in particular, it relates to thin film multi-junction photovoltaic modules, such as organic multi-junction photovoltaic modules.

**Background of the invention**

The energy conversion efficiency of single junction organic photovoltaic cells is relatively low, because of the narrow absorption spectrum of the organic materials commonly used in the active layer of organic photovoltaic cells. Therefore, in an organic photovoltaic cell typically only a small part of the incoming light is absorbed and converted to electrical power. The remaining part of the incoming light is not absorbed and therefore does not contribute to the generation of electrical power.
Several approaches have been followed to improve the conversion of incoming light into electrical power, wherein organic photovoltaic cells are formed by the interconnection of two or more organic photovoltaic sub-cells.
By placing two or more organic photovoltaic sub-cells on top of each other, the part of the incoming light that is not absorbed in the upper sub-cell, i.e. the sub-cell that is closest to a light source, can be further transmitted to an underlying sub-cell. Such underlying sub-cell typically comprises other active layer materials than the upper sub-cell, allowing absorption of the part of the incoming light that is transmitted by the upper sub-cell. Such a configuration corresponds to an optical series connection of two or more sub-cells.
The sub-cells may be electrically connected in series or in parallel, or a combination of series and parallel connections may be used.
Stacking of photovoltaic cells, e.g. organic photovoltaic cells, wherein at least two sub-cells operating in different spectral regions are stacked on top of each other, can result in improved performance because a broader part of the spectrum of the incoming light can successfully be absorbed and converted by the stack of sub-cells.
However, matching of the short-circuit currents of the different sub-cells (which is especially relevant when the stacked sub-cells are electrically connected in series) is not guaranteed and is strongly influenced by mutual interactions (such as e.g. partial overlapping absorption spectra between the sub-cells, optical interference effects, electrical conductivity or temperature dependent variations) as well as varying illumination conditions.
Similarly, matching of the open-circuit voltages of the stacked sub-cells (which is especially relevant when the stacked sub-cells are electrically connected in parallel) is not guaranteed and is strongly influenced by mutual interactions as well as varying illumination conditions.
Typically, stacked cells are optimized to operate under standardized illumination conditions. However, under realistic illumination conditions, spectral variations and partial shadowing of the cells may result in a non-optimal performance of the stacked photovoltaic cells.
Furthermore, in case of non-identical sub-cells (i.e. in case of current mismatching and/or voltage mismatching between sub-cells) the performance of a stacked cell is to a large extent determined (i.e. limited) by the weakest sub-cell in the stack.
US-A-4784701 discloses a multi-junction photovoltaic device comprising first and second stacked sub-modules that are electrically connected in parallel, wherein each sub-module comprises series-connected sub-cells based on a-Si.
US-A-20050217717 discloses multi-junction photovoltaic devices comprising both monolithically and mechanically stacked sub-modules, the sub-modules comprising inorganic or organic photovoltaic cells.
US-A-4847669 discloses a multi-junction photovoltaic device comprising first and second stacked sub-modules that are electrically connected in series, the sub-modules comprising inorganic series-connected photovoltaic cells, with the cells of the first and second sub-modules having different area sizes.

**Aims of the Invention**

The present invention aims to provide a photovoltaic multi-junction device that does not present the drawbacks of prior art devices for the production of electrical power (i.e. for the conversion of optical power into electrical power).
It is an aim of the present invention to provide multi-junction organic photovoltaic modules wherein the electrical power output of the module is less sensitive to varying illumination conditions as compared to prior art solutions and wherein the electrical power output of the module is less sensitive to stringent current matching and/or voltage matching of stacked sub-cells as compared to prior art solutions.
It is a further aim of the present invention to provide methods for fabricating such multi-junction organic photovoltaic modules.

## Summary of the Invention

The present invention is directed to a multi-junction photovoltaic module in accordance with claim 1

and a method for fabricating a multi-junction photovoltaic module in accordance with claim 5.

Advantageously, under illumination, the first photovoltaic cells have an open circuit voltage of $V_{oc1}$, the second photovoltaic cells have an open circuit voltage $V_{oc2}$ and N $V_{oc1}$ does not differ from M $V_{oc2}$ by more than 10%, preferably not more than 5%, more preferably not more than 2%, still more preferred not more than 1%.

Preferably, the first photovoltaic cells and the second photovoltaic cells are organic cells.

Preferably the plurality of first photovoltaic cells comprise a first active material and the plurality of second photovoltaic cells comprise a second active material different from the first active material.

Preferably, the first photovoltaic sub-module and the second photovoltaic sub-module are stacked with their device side oriented towards each other.

Alternatively, the first and second substrates are two sides of one transparent substrate.

Advantageously, The multi-junction photovoltaic module may further comprise additional sub-modules optically in series with the first and second sub-modules, each of the additional sub-modules comprising a plurality of ki additional photovoltaic cells connected in series, said additional photovoltaic cells being (substantially) identical and being provided on an additional substrate.

Preferably, under illumination, each of the additional sub-modules have (exhibit) an open circuit voltage $V_{oci}$ and ki.$V_{oci}$ does not differ from N.$V_{oc1}$ by more than 10%%, preferably not more than 5%, more preferably not more than 2%, still more preferred not more than 1%.

Preferably, the additional photovoltaic cells are monolithically integrated on each of the additional substrate.

The multi-junction photovoltaic module may comprise up to three additional sub-modules.

Preferably, the method for fabricating a multi-junction photovoltaic module further comprises the step of encapsulating the multi-junction photovoltaic module.

## Brief Description of the Drawings

Fig 1(a) illustrates an organic photovoltaic cell comprising a first electrode, an active layer and a second electrode on a substrate.

Fig 1(b) illustrates an organic photovoltaic cell comprising an additional hole transport layer and an additional electron transport layer.

Fig. 2 shows an IV curve of an illuminated photovoltaic cell, illustrating short-circuit current, open-circuit voltage, and maximum power point.

Fig. 3(a) illustrates the electrical series connection of two photovoltaic cells.

Fig. 3(b) illustrates the electrical parallel connection of two photovoltaic cells.

Fig. 4 illustrates the effect on the IV curves of electrically connecting two photovoltaic cells:

- Fig. 4(a) illustrates the effect of electrical series connection of two identical cells;
- Fig. 4(b) illustrates the effect of electrical series connection of two non-identical cells;
- Fig. 4 (c) illustrates the effect of electrical parallel connection of two identical cells;
- Fig. 4(d) illustrates the effect of electrical parallel connection of two non-identical cells.

Fig. 5 illustrates stacking of sub-cells.

Fig. 6 schematically shows an organic photovoltaic sub-module the useful for understanding the present invention.

Fig. 7 schematically shows an organic photovoltaic module comprising two stacked sub-modules according to the present invention.

## Detailed Description of the Invention

The present invention discloses a photovoltaic module, preferably an organic photovoltaic module, that comprises at least two (organic) photovoltaic sub-modules that are separately fabricated and that are stacked on top of each other. Each of the (organic) photovoltaic sub-modules comprises a plurality of substantially identical (sub-)cells that are monolithically integrated on a substrate and that are electrically connected in series.

The different photovoltaic sub-modules are stacked on top of each other, i.e. optically connected in series, and electrically connected in parallel.

It is an advantage of an (organic) photovoltaic module of the present invention that the (sub-)cells within each sub-module can be substantially identical, and thus can be substantially current matched and voltage matched.

It is an advantage of electrically connecting the sub-modules in parallel that.the need for current matching between the (sub-)cells of different sub-modules is avoided.

It is an advantage of using separately fabricated sub-modules that the area of the (sub-)cells of different sub-modules may be different, such that the number of (sub-)cells in each sub-module can be selected independently.

Therefore, by appropriate and independent selection of the number of (sub-)cells for each sub-module, the output voltages of the different sub-modules can be made substantially equal, and thus voltage matching can be obtained.

The sub-cells within a sub-module being identical and being connected in series, the output voltage of a sub-module is calculated by multiplying the output voltage of an individual sub-cell of said sub-module by the number of cells comprised in said sub-module.

It is an advantage of the invention that no DC-DC voltage converter are needed to obtain voltage matching between the sub-modules. Therefore, the multi-junction photovoltaic sub-modules according to the present invention preferably do not comprise DC-DC converters electrically connected in series with individual sub-modules. The use of such converters induces an increased complexity of the device, with the need for power electronics, and, reduces the total efficiency of the device, due to power losses in the converter.

A multi-junction photovoltaic module according to the present invention comprises a first photovoltaic sub-module and a second photovoltaic sub-module stacked on the first photovoltaic sub-module, wherein the first photovoltaic sub-module comprises a plurality of first photovoltaic (sub-)cells that are monolithically integrated on a first substrate and wherein the second photovoltaic sub-module comprises a plurality of second photovoltaic (sub-)cells that are monolithically integrated on a second substrate. The first photovoltaic (sub-)cells and the second photovoltaic (sub-)cells may be organic (sub-)cells.

Optionally, the multi-junction photovoltaic module may comprise more than two photovoltaic sub-modules.

The plurality of first photovoltaic (sub-)cells are substantially identical and the plurality of second photovoltaic (sub-)cells are substantially identical. The plurality of first photovoltaic (sub-)cells are substantially different from the plurality of second photovoltaic (sub-)cells.

Preferably, the plurality of first photovoltaic (sub-)cells comprises a first active material and the plurality of second photovoltaic (sub-)cells comprises a second active material different from the first active material.

Advantageously, the first active material is selected for providing good (optimal) absorption (and conversion) of light that is not absorbed by the second active material.

The plurality of first photovoltaic (sub-)cells have a first active area size and the plurality of second photovoltaic (sub-)cells have a second active area size, the first active area size being substantially different from the second active area size.

The first active area size and the second active area size are selected for resulting in substantially equal output voltages of the different sub-modules.

The area of individual (sub-)cells are determining their number in a sub-module, as the number of (sub-)cell within a sub-module approximately equals the total area of the sub-module divided by the area of an individual sub-cell.

Under illumination, a first photo-voltage generated by the first photovoltaic sub-module and a second photo-voltage generated by the second photovoltaic sub-module are substantially equal.

The plurality of first photovoltaic (sub-)cells are electrically connected in series and the plurality of second photovoltaic (sub-)cells are electrically connected in series. The first photovoltaic sub-module and the second photovoltaic sub-module are electrically connected in parallel.

Preferably, at least one of the first photovoltaic sub-module and the second photovoltaic sub-module comprises an electronic device integrated within the sub-module, such as for example a power control device, a diode, an inverter.

Advantageously, the first photovoltaic sub-module and the second photovoltaic sub-module are stacked with their device side oriented towards each other, with their substrate side oriented towards each other, or with the substrate side of the second photovoltaic sub-module oriented towards the device side of the first photovoltaic sub-module or vice versa.

The present invention further provides a method for fabricating a multi-junction photovoltaic module, e.g. a multi-junction organic photovoltaic module, the method comprising: fabricating a first photovoltaic sub-module comprising a plurality of first photovoltaic (sub-)cells; fabricating a second photovoltaic sub-module comprising a plurality of second photovoltaic (sub-)cells; and stacking the second photovoltaic sub-module on the first photovoltaic sub-module.

The plurality of first photovoltaic (sub-)cells are electrically connected in series and the plurality of second photovoltaic (sub-)cells are electrically connected in series.

Fabricating the first photovoltaic sub-module comprises providing on a first substrate a plurality of substantially identical monolithically integrated first photovoltaic (sub-)cells and fabricating the second photovoltaic sub-module comprises providing on a second substrate a plurality of substantially identical monolithically integrated second photovoltaic (sub-)cells.

The plurality of first photovoltaic (sub-)cells are substantially different from the plurality of second photovoltaic (sub-)cells.

The method further comprises electrically connecting the first photovoltaic sub-module with the second photovoltaic sub-module, e.g. electrically connecting the sub-modules in parallel.

Advantageously, the multi-junction photovoltaic module is encapsulated and electrical connections are provided, e.g. for electrically connecting the module to an external load.

In the following detailed description, numerous specific details are set forth in order to provide a thorough understanding of the invention and how it may be practiced in particular embodiments. However it will be understood that the present invention may be practiced without these specific details. In other instances, well-known methods, procedures and techniques have not been described in detail, so as not to obscure the present invention. While the present invention will be described with respect to particular embodiments and with reference to certain drawings, the reference is not limited hereto.

The drawings included and described herein are schematic and are not limiting the scope of the invention. It is also noted that in the drawings, the size of some elements may be exaggerated and, therefore, not drawn to scale for illustrative purposes.

Moreover, the terms top, bottom, over, under and the like in the description are used for descriptive purposes and not necessarily for describing relative positions. It is to be understood that the terms so used are interchangeable under appropriate circumstances and that the embodiments of the invention described herein are capable of operation in other orientations than described or illustrated herein.

In the context of the present invention, the front surface or front side of a photovoltaic sub-cell or a photovoltaic cell or of a photovoltaic sub-module or a photovoltaic module is the surface or side adapted for being oriented towards a light source and thus for receiving illumination.

The back surface or back side of a photovoltaic sub-cell, a photovoltaic cell, a photovoltaic sub-module or a photovoltaic module is the surface or side opposite to the front surface or side.

It is preferred in the present invention that the photovoltaic (sub-)cells comprises an organic active material. However, the invention is not limited thereto and can be used for photovoltaic (sub-)cells comprising other active layer materials, e.g. thin-film materials.

The present invention relates to multi-junction (organic)photovoltaic modules and to methods for fabricating such modules.

Preferably, said multi-junction photovoltaic modules are multi-junction organic photovoltaic modules.

In the present invention, at least two separately fabricated (organic)photovoltaic sub-modules, each comprising a plurality of substantially identical(organic) photovoltaic (sub-)cells on a substrate, are stacked on top of each other (i.e. optically connected in series) and electrically connected to each other.

The sub-modules are electrically connected in parallel.

The photovoltaic (sub-)cells within each photovoltaic sub-module are electrically connected in series.

The (sub-)cells may be single junction or multi-junction (organic) photovoltaic cells.

Each photovoltaic sub-module comprising a plurality of substantially identical (organic) photovoltaic (sub-)cells means that within each sub-module the plurality of (sub-)cells is substantially identical.

However, between the different (organic) photovoltaic sub-modules the (sub-)cells are preferably substantially different.

The lower sub-module, i.e. the sub-module that is provided closest to the back surface of the photovoltaic module, comprises photovoltaic (sub-)cells having at least one transparent electrode. More particularly, at least the electrode of this lower sub-module that is closest to the front surface of the sub-module is a transparent electrode.

Preferably, the other sub-module(s) comprise(s) photovoltaic (sub-)cells with two transparent electrodes, formed on a transparent substrate, forming transparent sub-module(s).

Said transparent sub-modules allows a (substantial) part of the incoming light not absorbed by said previous sub-module(s) to pass through the layer for further electrical conversion in the next (underlying) sub-module(s).

Other elements (devices), such as diodes or rectifiers can be integrated in a photovoltaic module of the present invention.

Inverters can advantageously be integrated in the photovoltaic module of the present invention to convert the output DC current to standard AC current.

It is an advantage of an (organic) photovoltaic module of the present invention that the (sub-)cells within each sub-module are substantially identical, and thus are substantially current matched and voltage matched.

It is an advantage of electrically connecting the sub-modules in parallel that the need for current matching between the (sub-)cells of the different sub-modules is avoided.

It is an advantage of using separately fabricated sub-modules that the area of the (sub-)cells of different sub-modules may be different, such that the number of (sub-)cells in each sub-module can be selected independently.

Advantageously, by appropriate and independent selection of the number of (sub-)cells for each sub-module, the output voltages of the different sub-modules are made substantially equal, and thus voltage matching is easily obtained.

Preferably, the (organic) photovoltaic sub-modules comprise a plurality of (organic) photovoltaic (sub-)cells formed on a substrate.

In the further description, the side of the substrate where the (sub-)cells are formed is indicated as the 'device side' of the sub-module, and the opposite side of the substrate is called the 'substrate side' of the sub-module.

When stacking sub-modules on top of each other to form a multi-junction (organic) photovoltaic module according to the present invention, subsequent sub-modules can be stacked with their substrate sides oriented towards each other, with their device sides oriented towards each other, or with the device side of one sub-module oriented towards the substrate side of the subsequent sub-module or vice versa.

The present invention is further described for an (organic) multi-junction photovoltaic module comprising two sub-modules. However, the invention is not limited thereto and is also applicable for (organic) multi-junction photovoltaic modules comprising more than two sub-modules.

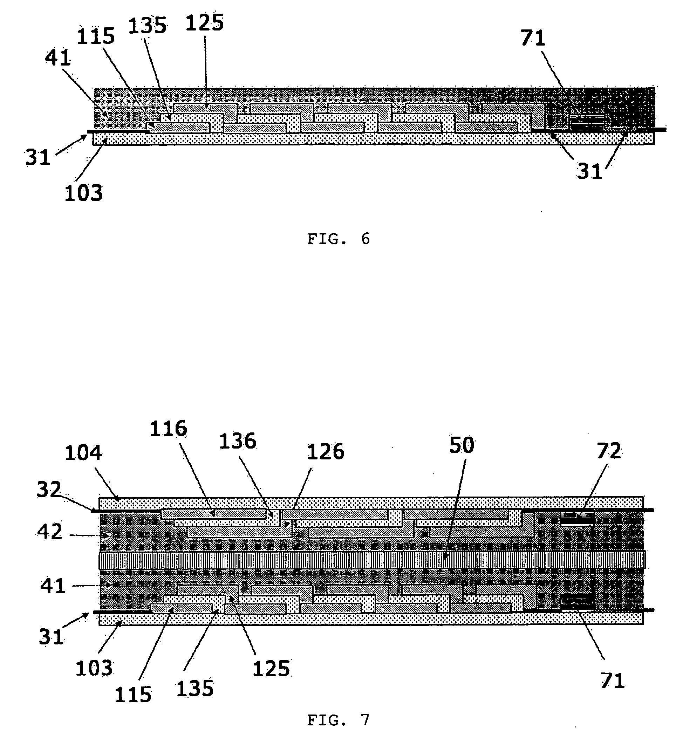

The present invention is further described for a case where the two sub-modules are stacked with their device side oriented towards each other (as e.g. illustrated in Fig. 7).

The (organic) photovoltaic (sub-)cells within each sub-module are electrically connected in series and the two sub-modules are electrically connected in parallel.

An (organic) multi-junction photovoltaic module according to the present invention comprises a first (organic) photovoltaic sub-module and a second (organic) photovoltaic sub-module, the first (organic) sub-module being adapted for being located closest to the back surface of the module and the second (organic) sub-module being adapted for being located closest to the front side of the module.

Preferably, the first (organic) photovoltaic sub-module comprises a plurality of, e.g. an array of first (organic) photovoltaic (sub-)cells or photovoltaic sub-cell stacks, monolithically interconnected with each other in series and being adapted for absorbing a first predetermined part of the incident light spectrum, e.g. solar spectrum.

The (organic) photovoltaic cells of the first sub-module have a first active area size. They have at least one transparent electrode. More in particular, at least the front side electrode, i.e. the electrode closest to the front surface, is transparent.

The (organic) photovoltaic cells of the first sub-module may be formed on a transparent substrate or on a non-transparent substrate. The first (organic) photovoltaic sub-module may comprise other elements such as for example rectifying devices or switching devices.

The second (organic) photovoltaic sub-module comprises a plurality of, e.g. an array of second (organic) photovoltaic (sub-)cells or photovoltaic sub-cell stacks, preferably monolithically interconnected with each other in series and being adapted for absorbing a second predetermined part of the solar spectrum, the second predetermined part of the solar spectrum being different from the first predetermined part of the solar spectrum.

The (organic) photovoltaic (sub-)cells of the second sub-module have a second active area size that are preferably different from the first active area size. They have two transparent electrodes and are formed on a transparent substrate.

The second (organic) photovoltaic sub-module may comprise other elements such as for example rectifying devices or switching devices.

Fabrication of a photovoltaic module according to the present inventions comprises: fabricating a first (organic) sub-module comprising a plurality of first (organic) photovoltaic (sub-)cells on a first substrate; fabricating a second (organic) sub-module comprising a plurality of second (organic) photovoltaic (sub-)cells on a second substrate, the second substrate being an optically transparent substrate; mechanical stacking of the second (organic) sub-module on top of the first (organic) sub-module; and electrically interconnecting the first (organic) sub-module with the second (organic) sub-module.

The (organic) photovoltaic sub-modules comprise at least one (organic) photovoltaic sub-cell, preferably a plurality of (organic) photovoltaic (sub-)cells on a substrate.

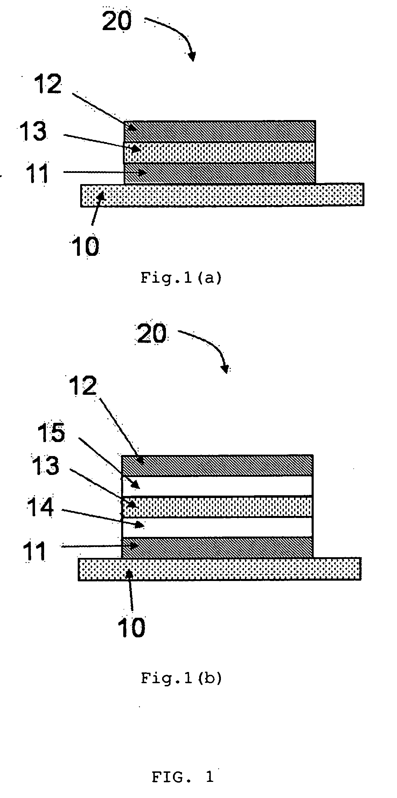

As illustrated in Fig. 1(a), an organic photovoltaic sub-cell 20 typically comprises a first electrode 11 on a substrate 10, an active layer 13 adjacent to the first electrode 11 and a second electrode 12 adjacent to the active layer 13 and at an opposite side of the active layer as compared to the first electrode 11.

The substrate 10 may comprise an optically transparent material such as for example glass or a polymeric foil such as e.g. PET or PEN. The substrate 10 may be a flexible substrate.

For the first photovoltaic sub-module, located closest to the back surface of the organic photovoltaic module of the present invention, also a non-transparent substrate 10 may be used, such as for example a ceramic substrate or a metallic foil with a non-conductive surface. This is the case when, after stacking the photovoltaic sub-modules to form an organic photovoltaic module according to the present invention, the first organic photovoltaic sub-module is oriented with its substrate side closest to the back surface of the module and with its device side closer to the front surface of the module.

The first electrode 11 and the second electrode 12 may comprise an optically transparent conductor such as for example TiOx, ITO (Indium Tin Oxide), ZnO, AZO (Aluminum doped ZnO), FTO (fluorine doped Tin Oxide) or thin metallic layers such as for example layers comprising e.g. Au, Ag, or Cu or metallic compound layers such as Mg:Ag. The first electrode 11 and the second electrode 12 can also comprise conductive polymers such as e.g. PEDOT (Poly (3,4-ethylenedioxythiophene)) or PANI (Polyaniline). These conductive polymers can be doped to increase the conductivity, for example they can be doped with anions, metallic nanoparticles, nanotubes or any other suitable material known by a person skilled in the art.

Furthermore, an electrically conductive grid, e.g. a metallic grid (e.g. comprising Cu or Ag) can be provided adjacent to the first electrode 11 and/or the second electrode 12 to further enhance the conductivity without creating high losses in optical transparency.

The material of the first electrode 11 and the second electrode 12 can be provided, e.g. deposited, on the substrate 10 by means of several techniques, such as for example thermal evaporation in vacuum, sputtering, chemical vapor deposition or solution processing wherein the materials to be deposited are dissolved in appropriate solvents in appropriate quantities to be handled in processes such as e.g. spincoating, doctor blading, inkjet printing, screen printing, gravure printing, flexo printing, slot die coating, spray coating or alike.

The (sub-)cells of the first photovoltaic sub-module located at the back side of the organic photovoltaic module of the present invention may comprise a first electrode 11 that is optically non-transparent, such as for example a metal electrode comprising for example Ba, Ca, Mg, Al, Ag or Cu or metal alloys comprising two or more metals. This is the case when, after stacking the photovoltaic sub-modules to form an organic photovoltaic module according to the present invention, the first organic photovoltaic sub-module is oriented with its substrate side closest to the back surface of the module and with its device side closer to the front surface of the module.

The active layer 13 of an organic photovoltaic sub-cell 20 comprises at least one light-absorbing layer, wherein light absorption results in the generation of electrical charges.

The active layer 13 can comprise more than one light-absorbing, charge generating layer when these light-absorbing, charge generating layers are separated from each other by a charge recombination layer.

The active layer 13 comprises materials that are suitable for absorption of the incoming light and for charge carrier generation and transport of charge carriers to the adjacent electrodes 11, 12. It can comprise a single layer or two adjacent layers of different organic conjugated materials. If two layers of different materials are used, there can be intentional or unintentional mixing of these two materials in the proximity of the interface between the two materials.

The active layer 13 can also comprise a mixture of two or more different organic conjugated materials in a single layer. The active layer 13 can also comprise a mixture of an organic conjugated material with metallic or semiconducting non-conjugated materials.

Organic conjugated materials can comprise materials such as for example polymers, e.g. polyphenylene, polyphenylenvinylene, polythiophene, polyfluorene and their derivatives, or for example low molecular weight molecules, e.g. pentacene, perylene, anthracene, naphthalene, phthalocyanine and their derivatives, or for example fullerenes, e.g. C60, C70 and their derivatives, or for example nanotubes, e.g. SWCNT (Single Walled Carbon NanoTubes), MWCNT (Multi Walled Carbon NanoTubes) and their derivatives.

The materials of the active layer 13 can be deposited by means of several techniques, such as for example thermal evaporation in vacuum, wherein eventually an additional inert carrier gas such as e.g. nitrogen or argon can be introduced to guide the material efficiently onto the electrode.

An alternative method for providing the materials of the active layer 13 is OVPD (Organic Vapor Phase Deposition). The materials of the active layer 13 can for example also be deposited by means of solution processing, wherein the materials to be deposited are dissolved in appropriate solvents in appropriate quantities to be handled in processes such as e.g. spincoating, doctor blading, inkjet printing, screen printing, gravure printing, flexo printing, slot die coating, or spray coating.

Fig. 1(b) shows a structure of an organic photovoltaic sub-cell in which two additional layers 14, 15 are present as compared to the structure shown in Fig. 1(a). These additional layers 14 and 15 are optional, i.e. they may or may not be present in the photovoltaic sub-cell, or one of these layers may be provided in the sub-cell while the other one is not.

The substrate 10 and the first electrode 11 are similar to the corresponding layers shown in Fig. 1(a). Layer 14 acts as a hole transport layer (HTL) to facilitate the collection by the first electrode 11 of positive charge carriers generated in the active layer 13. Layer 15 acts as an electron transport layer (ETL) to facilitate the collection by the second electrode 12 of negative charge carriers generated in the active layer 13.

The selection of materials for the two additional layers 14, 15 is also determined by the necessity of optical transparency in the given structure. Also the value of energy levels like valence band, conduction band, Fermi level, HOMO (Highest Occupied Molecular Orbital) and LUMO (Lowest Unoccupied Molecular Orbital) of the materials for layer 14, 15 with respect to the corresponding energy levels of the materials in the active layer 13 or the electrodes 11, 12. A further criterion for the selection of materials for layers 14, 15 can be the electrical conductivity for either positive or negative charge carriers. An appropriate selection of materials for the layers 14, 15 can be made by a person skilled in the art.

The hole transport layer 14 may for example comprise conjugated materials such as e.g. polyaniline, polythiophene or polyphenylene and their derivatives. The hole transport layer may also comprise conjugated materials in which other materials such as for example carbon nanotubes and their derivatives are dispersed. The hole transport layer may comprise low molecular weight molecules such as for example perylene, naphthalene and their derivatives or ZnO, AZO, FTO, ITO.

The electron transport layer 15 may comprise for example fullerenes such as C60, C70. and their derivatives, or for example nanotubes, e.g. SWCNT, MWCNT and their derivatives. The electron transport layer may also comprise low molecular weight molecules such as for example BCP, $Alq_3$, TPD or materials such as e.g. ZnO, AZO, FTO, ITO.

The hole transport layer 14 and the electron transport layer 15 can be deposited by means of several techniques, such as for example thermal evaporation in vacuum, chemical vapour phase deposition or similar techniques, sputtering or solution processing wherein the materials to be deposited are dissolved in appropriate solvents in appropriate quantities to be handled in processes such as e.g. spincoating, doctor blading, inkjet printing, screen printing, gravure printing, flexo printing, slot die coating, spray coating or alike.

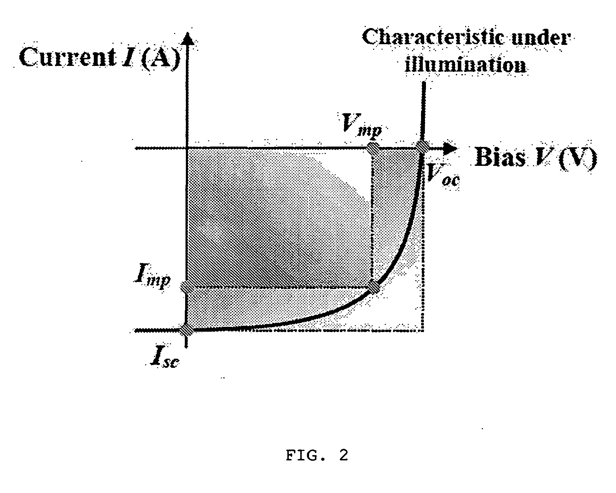

The basic parameters describing the performance of a photovoltaic cell or sub-cell can be extracted from a current-voltage (IV) graph. This results from a measurement in which the external electrical current is measured as a function of an externally applied voltage. A typical IV characteristic of an illuminated photovoltaic cell is shown in Fig. 2. As a result of the illumination, charge carriers are generated and the IV curve passes through the fourth quadrant, meaning that power P = I.V can be extracted from the device. The point ($V_{mp}$, $I_{mp}$) where this power output has its maximum value is called the maximum power point $P_{mp}$ and is given by:

$$P_{mp} = V_{mp}.I_{mp} \qquad (1)$$

This product corresponds also to the area of the smaller rectangle indicated in Fig. 2.

There are two other relevant parameters shown in this figure. The short-circuit current $I_{sc}$ is the electrical current flowing through the device under illumination when no external voltage is applied (V = 0 V). Since the actually measured short-circuit current depends on the active area of a photovoltaic device, it is often more common to use the short-circuit current density $J_{sc}$. It results from dividing the measured short-circuit current by the active area A of the solar cell. The open-circuit voltage $V_{oc}$ is the value of the external bias at which no external current is flowing through the illuminated device (I = 0 A).

Analogous to the coordinates of the maximum power point, $I_{sc}$ and $V_{oc}$ determine a second rectangle as illustrated in Fig. 2. It can be seen from this drawing that the difference in area of the two rectangles is smaller when the IV curve has a more rectangular shape. The ratio of the areas of the two rectangles can therefore be regarded as a measure of the quality of the shape of the IV characteristic; it is called the fill factor FF:

$$FF = \frac{V_{mp}.I_{mp}}{V_{oc}.I_{sc}} \qquad (2)$$

The product of $I_{sc}$ and $V_{oc}$ can be considered as the theoretical upper limit for the total power that can be delivered to an external load. The fill factor FF can therefore be considered as the ratio of the actual maximum power extracted to this theoretical upper limit. Furthermore, these parameters relate to the energy-conversion efficiency $\eta_e$ as follows:

$$\eta_e = \frac{P_{mp}}{P_{in}} = \frac{V_{mp}.I_{mp}}{P_{in}} = \frac{V_{oc}.I_{sc}.FF}{P_{in}} \qquad (3)$$

expressing how much of the total power Pin of the light incident on the active area of the photovoltaic cell is converted into electric power $P_{mp}$.

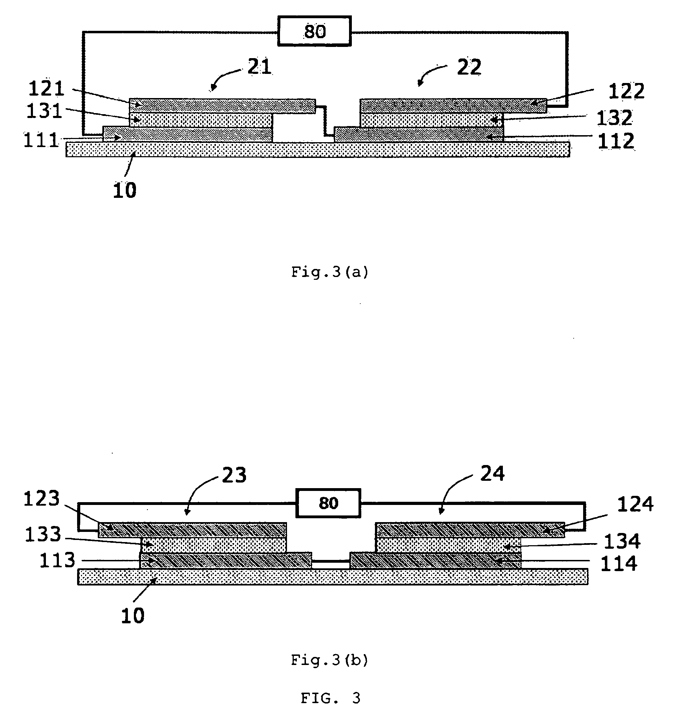

Fig. 3(a) shows two organic photovoltaic cells 21, 22 next to each other on a single substrate 10. The electrodes 111 and 121 of the first organic photovoltaic cell 21 and the electrodes 112 and 122 of the second organic photovoltaic cell 22 have an area that is larger than the area of the active layer 131, 132 of the cells. This allows realizing electrical connections by e.g. wiring, thereby electrically connecting the cells 21, 22 with each other or with an external load 80. By placing the cells 21, 22 next to each other as illustrated in Fig 3(a), they are positioned optically in parallel to the light incident on the photovoltaic cells. It is clear that photovoltaic cells which are fabricated on distinct substrates can also be placed in a configuration that allows the cells to be optically in parallel.

Fig. 3(a) illustrates electrical wiring between the second electrode 121 of the first photovoltaic cell 21 and the first electrode 112 of the second photovoltaic cell 22 and electrical wiring between the second electrode 122 of the second photovoltaic cell 22 and the first electrode 111 of the first photovoltaic cell 21. This wiring corresponds to an electrical series connection of the first photovoltaic cell 21 and the second photovoltaic cell 22.

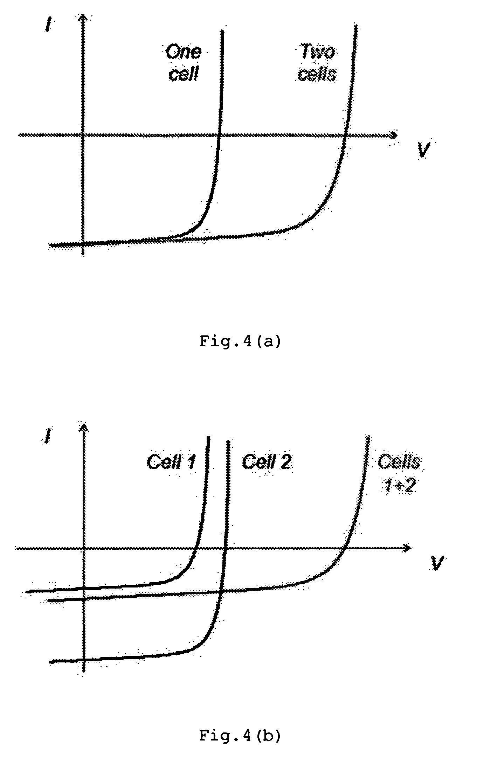

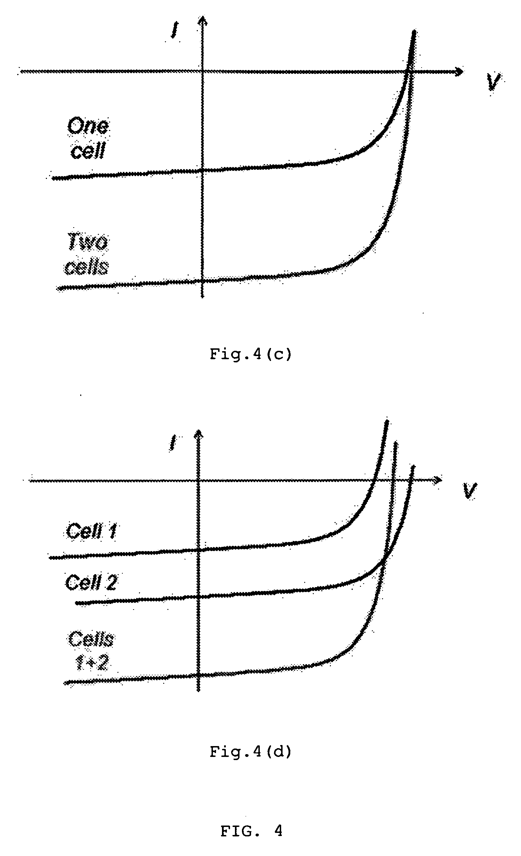

In case of an electrical series connection of two substantially identical photovoltaic cells, under short-circuit conditions the externally extracted current equals the photo-generated current of a single cell. On the other hand, under open-circuit conditions, the open-circuit voltage is the sum of the open-circuit voltages of the two separate photovoltaic cells. Therefore, a series connection of two substantially identical photovoltaic cells results in the IV characteristic as shown in Fig. 4(a). The maximum power generated by the two cells connected in series substantially equals the sum of the individually developed powers, with a doubling of the output voltage.

For non-identical series-connected photovoltaic cells, i.e. for series-connected photovoltaic cells with e.g. different short-circuit currents, the situation is more complex. In such a case of current mismatching the weakest cell, i.e. the cell generating the smallest short-circuit current, strongly limits the total performance. Whereas the total open-circuit voltage is not strongly influenced by the current mismatching, the total current in this case is almost completely determined by the weakest cell.

If the IV characteristics of the individual cells are known then the curve for the series interconnected cells can be predicted. For each current, the different voltages of the individual cells can be added, as illustrated in Fig. 4(b). Obviously, the total power generated by the two mismatched cells is substantially smaller than the addition of the powers produced by the individual cells. Therefore, series connection of photovoltaic cells is only advantageous for cells with substantially equal short-circuit currents.

Fig. 3(b) shows two organic photovoltaic cells 23, 24 next to each other on a single substrate 10. The electrodes 113 and 123 of the first organic photovoltaic cell 23 and the electrodes 114 and 124 of the second organic photovoltaic cell 24 have an area that is larger than the area of their active layers 133, 134. This allows realizing electrical connections by e.g. wiring, thereby electrically connecting the cells with each other or with any external load 80.

By placing the cells next to each other as illustrated in Fig. 3(b), they are positioned optically in parallel. It is clear that photovoltaic cells which are fabricated on distinct substrates can still be placed in a configuration that allows the cells to be optically in parallel.

Electrical wiring between the first electrode 113 of the first organic photovoltaic cell 23 and the first electrode 114 of the second organic photovoltaic cell 24 and electrical wiring between the second electrode 123 of the first photovoltaic cell 23 and the second electrode 124 of the second photovoltaic cell 24 is illustrated in Fig. 3(b), corresponding to an electrical parallel connection of the first photovoltaic cell 23 and the second photovoltaic cell 24.

In case of an electrical parallel connection of two substantially identical photovoltaic cells, the total open-circuit voltage substantially equals the open-circuit voltage of a single cell. Under short-circuit conditions the externally extracted current is substantially equal to the sum of the photo-generated currents of the two individual cells 23, 24. Therefore, a parallel connection of two identical photovoltaic cells results in an IV characteristic as illustrated in Fig. 4 (c) . In this case the maximum power generated by the two substantially identical cells connected in parallel substantially equals the sum of the individually developed power, with a doubling of the output current.

Again the situation is more complex for non-identical photovoltaic cells. The IV characteristic of the parallel connection of two non-identical photovoltaic cells can be found by adding the currents of the individual cells at each voltage. The result for non-identical photovoltaic cells is illustrated in Fig. 4(d). It shows that the parallel connection of non-identical cells is limited by the cell generating the lowest output voltage. Therefore, parallel connection of solar cells is only of interest for cells with substantially equal open circuit voltages.

From this, it is clear that current mismatching and/or voltage mismatching of electrically connected cells may have a detrimental influence on the overall performance of a system comprising such interconnected cells.

Nevertheless, in the field of organic photovoltaic cells, several approaches have been followed to interconnect photovoltaic cells with each other to improve the conversion of the incoming light into electrical power. The main reason for this is the narrow absorption spectrum of the organic materials commonly used in the active layer. For this reason, in an organic photovoltaic cell typically only a small part of the incoming light is absorbed and can therefore be converted in electrical power. The rest of the incoming light is not converted and is therefore lost.

By placing several organic photovoltaic (sub-)cells on top of each other, the part of the incoming light that is not absorbed in a first sub-cell can be further transmitted to a next sub-cell comprising other materials in the active layer, allowing absorption of the part of the incoming light that is transmitted by the first sub-cell.

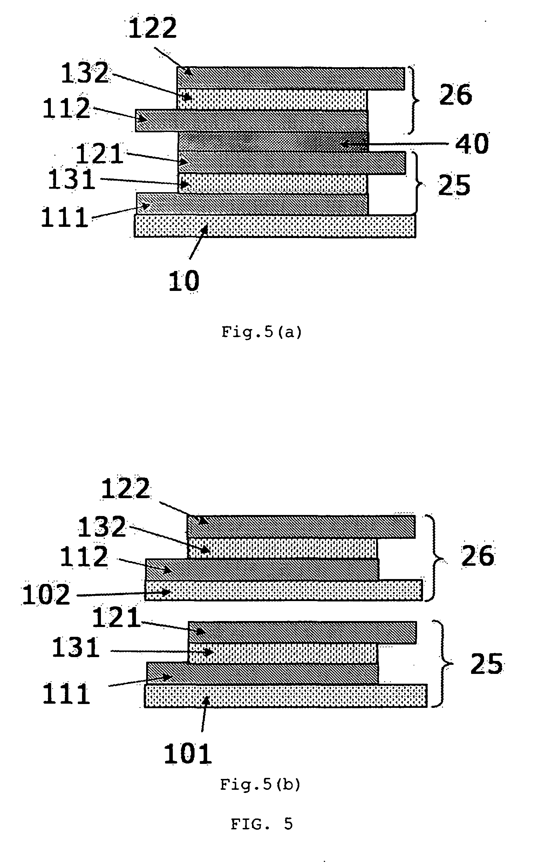

This means that two or more sub-cells 25, 26 are placed optically in series, as illustrated in Fig. 5(a) and 5(b). Fig. 5(a) illustrates stacking of two organic photovoltaic sub-cells 25, 26 on a single substrate 10 wherein the sub-cells can be electrically connected to each other in series or in parallel. Sub-cell 25 is formed on a substrate 10 and comprises a first electrode 111, active layer 131 and second electrode 121. Layer 40 is an optional layer that may be provided to facilitate stacking of the next sub-cell 26.. Layer 40 is optically transparent and can be electrically insulating. It can comprise materials such as e.g. polyfluoroethylene. It can also be electrically conductive and can then comprise materials such as Ag, Au, Al or TiOx, ZnO, ITO, AZO, FTO. Sub-cell 26 comprises a first electrode 112, active layer 132 and second electrode 122. Fig. 5(b) illustrates stacking of two organic photovoltaic sub-cells 25, 26 formed on separate substrates 101, 102, wherein the sub-cells can be electrically connected to each other in series or in parallel.

The concepts depicted in Fig. 5(a) and Fig. 5(b) correspond to prior art configurations that may result in an overall improvement of the energy conversion efficiency as compared to single organic photovoltaic cells because a broader part of the spectrum of the incoming light can successfully be absorbed by stacking organic photovoltaic sub-cells, i.e. by optically connecting the sub-cells in series. However, matching of the short-circuit currents of the different sub-cells (which is especially relevant when the stacked sub-cells are electrically connected in series) is not guaranteed and is strongly influenced by mutual interactions as well as varying illumination conditions. Similarly, matching of the open-circuit voltage for the stacked sub-cells (which is especially relevant when the stacked sub-cells are electrically connected in parallel) is not guaranteed and is strongly influenced by mutual interactions as well as varying illumination conditions.

In such prior art cells, the sub-cells are substantially aligned, all sub-cells in a cell having substantially the same area. Given varying illumination conditions and mutual interactions such as e.g. partially overlapping absorption spectra between sub-cells or temperature effects, it is difficult to design sub-cells having always the same short-circuit current, rendering series coupling of the sub-cells not optimal. On the other side, the sub-cells being optimized to absorb in a different part of the light spectrum and thus comprising different materials, they will usually produce a different open-circuit voltage, rendering series coupling of the sub-cells not optimal.

To overcome these problems, the present invention provides an (organic) photovoltaic module that is formed by stacking at least two (organic) photovoltaic sub-modules (as opposed to stacking of photovoltaic sub-cells), wherein problems of prior art solutions related to mismatching of the open-circuit voltage and/or mismatching of the short circuit-current of photovoltaic (sub-)cells are avoided.

A first (organic) photovoltaic sub-module comprises a plurality of substantially identical first (organic) photovoltaic (sub-)cells positioned next to each other on a first substrate, the plurality of first (organic) photovoltaic (sub-)cells being interconnected in series. In this way, the series connection of the (sub-)cells results in an addition of the open-circuit voltages of the substantially identical first (organic) photovoltaic (sub-)cells to a first open-circuit voltage.

Furthermore, the matching of short-circuit currents for the first (organic) photovoltaic (sub-)cells can be good (optimal) because substantially identical (sub-)cells are provided.

All first (organic) photovoltaic (sub-)cells being substantially identical, they are all characterised (under illumination) by the same open circuit voltage, $V_{c01}$. The first (organic) photovoltaic (sub-)cells within the first sub-module being connected in series, their voltage are summed. Given a first sub-module comprising N identical first (organic) photovoltaic (sub-)cells, the open circuit voltage is then N $V_{c01}$.

A second (organic) photovoltaic sub-module comprises a plurality of second (organic) photovoltaic (sub-)cells positioned next to each other on a second substrate and interconnected in series.

These second (organic) photovoltaic (sub-)cells are substantially identical to each other but can differ from the first (sub-)cells on the first substrate, e.g. by choice of materials and dimensions.

Matching of the short-circuit currents for the second (organic) photovoltaic (sub-)cells on the second substrate can be good (optimal) because substantially identical second (sub-)cells are provided.

Furthermore, by adapting the dimensions of the active area of the second (organic) photovoltaic (sub-)cells, the number of second (organic) photovoltaic (sub-)cells on the second substrate can be selected such that the second open-circuit voltage resulting from an addition of the open-circuit voltages of the second (organic) photovoltaic (sub-)cells connected in series substantially matches the first open-circuit voltage of the series connection of the first (organic) photovoltaic cells on the first substrate.

The second open-circuit voltage is mainly determined by the number of second (sub-)cells connected in series, and is to a large extent independent of the spectrum of the incoming light.

All second (organic) photovoltaic (sub-)cells being identical, they are all characterised (under illumination) by the same open circuit voltage, $V_{c02}$.

The second (organic) photovoltaic (sub-)cells within the second sub-module being connected in series, their voltage are summed. Given a second sub-module comprising M identical second (organic) photovoltaic (sub-)cells, the open circuit voltage is then M $V_{c02}$.

Therefore, the voltage matching can be obtained by providing the required numbers of identical (sub-)cells in each said sub-modules, namely N and M respectively (for two sub-modules) such that:

$$N \ V_{c01} \ = \ M \ V_{c02}$$

Usually, $V_{c01}$ and $V_{c02}$ being real numbers, and N and M being integers, a perfect equality will be difficult to achieve, but, differences of less than 10% already gives acceptable results. Preferably, the voltage matching between the sub-modules is better than 5%, more preferably better than 2%, still more preferred better than 1%.

The (organic) photovoltaic sub-modules can furthermore comprise on the same substrate an electronic device such as for example a power diode or an inverter, e.g. for optimizing the collection of electrical power generated by the photovoltaic sub-modules.

For example, a power diode can prevent electrical current flowing back to the photovoltaic (sub-)cells instead of flowing to an external load. An inverter may for example be provided for converting the direct current from the photovoltaic (sub-)modules into an alternating current, which may be more suitable to power a load, e.g. an external electrical device.

The second (organic) photovoltaic sub-module realized by the electrical series connection of the second (organic) photovoltaic (sub-)cells on the second substrate can be stacked, e.g. laminated, onto the first (organic) photovoltaic sub-module realized by the electrical series connection of the first (organic) photovoltaic cells on the first substrate.

As the first open-circuit voltage of the first sub-module and the second open-circuit voltage of the second sub-module substantially match, the first photovoltaic sub-module can advantageously be electrically connected in parallel with the second photovoltaic sub-module without suffering from voltage matching problems.

Before stacking the (organic) photovoltaic sub-modules, they are preferably covered by an insulating, optically transparent layer, for example comprising oxide, nitride, polyfluoroethylene or parylene or an equivalent material.

These insulating layers may further be covered by an optically transparent, adhesive layer such as an elastomer or a thermoplastic. Stacking of the sub-modules comprises placing the first and the second (organic) photovoltaic sub-module on top of each other such that they are physically attached to each other by the adhesive layer.

The materials and the thickness of the active layer of the first (organic) photovoltaic (sub-)cells in the first (organic) photovoltaic sub-module are preferably selected so as to optimize the optical absorption of the light that is not absorbed by the (organic) (sub-)cells of the second (organic) photovoltaic sub-module. If a third (organic) photovoltaic sub-module is included into the stack, the materials of the (organic) photovoltaic (sub-)cells in the first (organic) photovoltaic sub-module are preferably selected so as to optimize the optical absorption of the light that is not absorbed by the (organic) photovoltaic cells of the second and the third (organic) photovoltaic sub-module and the materials of the (organic) photovoltaic cells in the second (organic) photovoltaic sub-module are preferably selected so as to optimize the optical absorption of the light that is not absorbed by the (organic) photovoltaic cells of the third (organic) photovoltaic sub-module.

Fig. 7 schematically shows an organic photovoltaic module comprising two sub-modules according to the present invention. In Fig. 6 an example of a first organic photovoltaic sub-module is shown. On a substrate 103, a plurality of first organic photovoltaic (sub-)cells comprising a first electrode 115, a second electrode 125 and an active layer 135, can be formed next to each other. The layers 115, 125 and 135 can be formed in such a way that the second electrode 125 of an organic photovoltaic sub-cell makes direct electrical contact to the first electrode 115 of a neighboring organic photovoltaic sub-cell. In this way a series connection of organic photovoltaic (sub-)cells can be realized.

Furthermore, the organic photovoltaic sub-module can comprise electrical conductors 31, e.g. comprising a metal such as Ag, Au, Al or Cu, to enable external collection of the current generated by the first organic photovoltaic (sub-)cells. A first electrical conductor 31 may be connected to the first electrode 115 of a first photovoltaic sub-cell and a second electrical conductor 31 may be connected to the second electrode 125 of a first photovoltaic sub-cell. To control the current collection, an electronic device 71 can be provided and electrically connected to electrical conductors 31. The electronic device 71 can for example comprise a power diode or an inverter. For example, a power diode can prevent electrical current flowing back to the photovoltaic (sub-)cells instead of flowing to an external load. An inverter may for example be provided for converting the direct current from the photovoltaic sub-modules into an alternating current, which may be more suitable to power a load, e.g. an external electrical device.

The first organic photovoltaic sub-module can further comprise a layer 41, for example comprising a nitride, an oxide, polyfluoroethylene or parylene to ensure electrical insulation of this first organic photovoltaic sub-module with other sub-modules that may be stacked onto it.

A second organic photovoltaic sub-module can be fabricated in a similar way as the first organic photovoltaic sub-module, and can be stacked onto the first organic photovoltaic sub-module, as illustrated in Fig. 7. This stacking may require an additional layer 50 to strengthen the mechanical stacking.

The additional layer 50 may for example comprise elastomers, thermoplastics or thermosetting adhesives. The stacking comprises positioning the sub-modules on top of each other and mechanically bonding them to each other, for example by means of a process involving an increased temperature or an increased pressure or a combination of both.

As described above, the first organic photovoltaic sub-module is formed on a substrate 103 and comprises a plurality of first organic photovoltaic (sub-)cells with first electrode 115, second electrode 125 and active layer 135, electrical conductors 31, an insulating layer 41 and an electronic device 71.

The second organic photovoltaic sub-module has a similar structure, with a substrate 104, a plurality of second organic photovoltaic (sub-)cells with first electrode 116, second electrode 126 and active layer 136, electrical conductors 32, an insulating layer 42 and an electronic device 72.

The different layers of the second organic photovoltaic sub-module can comprise other materials as compared to the equivalent layers of the first organic photovoltaic sub-module and can be produced by other techniques than the respective layers of the first organic photovoltaic sub-module. Stacking of the organic photovoltaic sub-modules results in an optical series connection of the sub-modules.

After stacking the (organic) photovoltaic sub-modules, the resulting multi-junction photovoltaic module may be encapsulated and electrical connections may be provided through the encapsulation, for example for electrically connecting the module to an external load. The module may be encapsulated to prevent the intrusion of e.g. moisture, humidity of oxygen.

The encapsulation can for example be a flexible encapsulation, e.g. comprising a metallic layer such as Al at the back side and e.g. comprising a transparent layer or stack of layers, e.g. a stack of alternating polymeric and inorganic oxide layers at the front side.

A photovoltaic module according to the present invention allows that different parts of the spectrum of the incoming light can be absorbed in the photovoltaic (sub-)cells of the first (organic) photovoltaic sub-module and in the photovoltaic (sub-)cells of the second (organic) photovoltaic sub-module. In addition it allows that the (organic) photovoltaic (sub-)cells of the first (organic) photovoltaic sub-module can be fabricated independently of the photovoltaic (sub-)cells of the second (organic) photovoltaic sub-module. Therefore the power conversion efficiency of the photovoltaic (sub-)cells can be optimized for the part of the spectrum of the incoming light that can be absorbed by the respective photovoltaic (sub-)cells. This independent fabrication can involve e.g. choice of materials, thickness of layers, deposition techniques,...This independent fabrication can also involve the positioning of layers 115, 125 and 135 on substrate 103 and respectively the positioning of layers 116, 126 and 136 on substrate 104. Since different techniques can be used for these layers for the different sub-modules, for example the deposition accuracy and/or resolution as well as the orientation of the layers in the sub-modules can be selected independently. This independent fabrication can also involve the size and the number of photovoltaic (sub-)cells in the first photovoltaic sub-module, i.e. the size and the number of the first photovoltaic (sub-)cells formed on the first substrate 103, and respectively the size and the number of the second photovoltaic (sub-)cells formed on the second substrate 104.

By providing a configuration of stacked photovoltaic sub-modules according to the present invention, the prior art matching issues of photo-voltage and photo-current are addressed. On a first substrate 103 a plurality of substantially identical first (organic) photovoltaic (sub-)cells are provided next to each other and electrically connected in series. This series connection results in an addition/superposition of the photo-voltages generated by the different first (organic) photovoltaic (sub-)cells, such that a first sub-module photo-voltage is obtained.

Furthermore, substantial matching of the photo-currents of the different first organic photovoltaic (sub-)cells on this substrate 103 may be obtained because substantially identical first (sub-)cells are provided.

On a second substrate 104 a plurality of substantially identical second organic photovoltaic (sub-)cells are provided next to each other and electrically connected in series. These second organic photovoltaic (sub-)cells are substantially identical to each other but can be different from the first organic photovoltaic (sub-)cells on the first substrate 103, for example they can comprise different materials and they can have different dimensions. Substantial matching of the photocurrents of the different second organic photovoltaic (sub-)cells on this substrate 104 may also be obtained because substantially identical second (sub-)cells are provided.

Furthermore, by adapting the dimensions of the second (organic) photovoltaic (sub-)cells, the number of second (organic) photovoltaic (sub-)cells on the second substrate can be adapted such that the second sub-module photo-voltage resulting from an addition of the photo-voltages by the series connection of second (organic) photovoltaic (sub-)cells on this second substrate substantially matches the first sub-module photo-voltage resulting from an addition of the photo-voltages by the series connection of first (organic) photovoltaic (sub-)cells on the first substrate.

The second (organic) photovoltaic sub-module realized by the series connection of second (organic) photovoltaic (sub-)cells on the second substrate can then be stacked onto the first (organic) photovoltaic sub-module realized by the series interconnection of the first (organic) photovoltaic (sub-)cells on the first substrate.

The two (organic) photovoltaic sub-modules can then advantageously be electrically interconnected in parallel with each other since there is a good matching of the photo-voltages generated by the two sub-modules.

## Description of a Preferred Embodiment of the Invention

Using as a substrate a glass sheet, first electrodes are created by an Al layer which is deposited by vacuum evaporation. By use of shadow masking, a pattern is created in this Al layer such that multiple, adjacent and similar sized areas of the substrate are covered by the Al layer. Each of these multiple areas serves as an electrode of a cell of the first sub-module. The shadow masking results also in the creation of separated lines next to these multiple areas. These lines can serve in the end as electrical conductors to guide the generated electrical current towards an electrical circuit, either integrated on the same substrate or on an external carrier.

Further by vacuum evaporation and similar shadow masking, an active layer is deposited onto each Al electrode of the sub-module. This active layer consists of subsequent deposition of Buckminsterfullerene (C60) and subphthalocyanine (SubPc).

A hole transport layer of Molybdenumoxide (MoOx) is subsequently deposited on the active layer, by vacuum evaporation, using similar shadow masking.

To finalize the cells of the first sub-module, an indiumtinoxide (ITO) layer is sputtered. Also shadow masking is applied here to ensure that similar areas as the active layer and hole transport layer are covered. Though, care has been taken such that a slight displacement in position is realized in the subsequent layer depositions to create a series connection between adjacent cells, as depicted in Fig 6. This series connection is thus created by ensuring that the ITO layer of one cell makes direct electrical contact with the Al layer of an adjacent cell.

Further, the materials that are deposited on the substrate and that construct in this configuration organic photovoltaic cells that are connected in series with each other can then be covered by an optically transparent, electrically insulating material like parylene.

Following the deposition of this parylene layer, a deposition of an optically transparent, pressure sensitive adhesive layer is realized by spray coating.

Using now as a second substrate a sheet of poly(ethylenetheraphthalate) (PET), first electrodes of another sub-module are created by sputtering a layer of ITO. By use of shadow masking, a pattern is created in this ITO layer such that multiple, adjacent and similar sized areas of the substrate are covered by the ITO layer. Each of these multiple areas will serve as an electrode of a cell of the second sub-module.

Further by spray coating and similar shadow masking, a hole transport layer is deposited onto each ITO electrode of the sub-module. This hole transport layer consists of a poly(ethylene dioxythiophene) (PEDOT) layer into which poly(styrene sulfonate) (PSS) has been dispersed prior to deposition.

An active layer consisting of a mixture of poly(3-hexyl thiophene) (P3HT) and (6,6)-phenyl C61-butyric acid methyl ester (PCBM) is deposited on the hole transport layer by spray coating and similar shadow masking.

Further, titaniumoxide (TiOx) is deposited by spray coating and similar shadow masking to serve as an electron transport layer.

To finalize the cells of the second sub-module, an indiumtinoxide (ITO) layer is sputtered. Also shadow masking is applied here to ensure that similar areas as the electron transport layer, the active layer and hole transport layer are covered. Though, care has been taken such that a slight displacement in position is realized in the subsequent layer depositions to create a series connection between adjacent cells, as depicted in Fig 6.

This series connection is thus created by ensuring that the ITO layer of one cell deposited after the electron transport layer makes direct electrical contact with the ITO layer of an adjacent cell deposited directly onto the substrate.

Further, the materials that are deposited on the substrate and that construct in this configuration organic photovoltaic cells that are connected in series with each other is then covered by an optically transparent, electrically insulating material like parylene.

By use of the previously deposited adhesive layer, both sub-modules are then mechanically adhered to each other.

**Claims**

1. A multi-junction photovoltaic module comprising a first photovoltaic sub-module and a second photovoltaic sub-module stacked on the first photovoltaic sub-module, wherein:

   - the first photovoltaic sub-module comprises a plurality of N first photovoltaic sub-cells that are monolithically integrated on a first substrate and wherein the second photovoltaic sub-module comprises a plurality of M second photovoltaic sub-cells that are monolithically integrated on a second substrate where N and M are integers;
   - the plurality of N first photovoltaic sub-cells is substantially identical and has a first active area size;
   - the plurality of M second photovoltaic sub-cells is substantially identical and has a second active area size which is substantially different from the first active area size;
   - the plurality of first photovoltaic sub-cells is electrically connected in series;
   - the plurality of second photovoltaic sub-cells is electrically connected in series;
   - the first photovoltaic sub-module and the second photovoltaic sub-module are electrically connected in parallel, wherein
   - under illumination, all N first photovoltaic sub-cells are **characterised by** the same open circuit voltage $V_{C01}$, and all M second photovoltaic sub-cells are **characterised by** the same open circuit voltage $V_{C02}$, and wherein
   - under illumination, a first photo-voltage generated by the first photovoltaic sub-module is substantially equal to a second photo-voltage generated by the second photovoltaic sub-module.

2. The multi-junction photovoltaic module according to claim 1 wherein the first photovoltaic sub-cells and the second photovoltaic sub-cells are organic sub-cells.

3. The multi-junction photovoltaic module according to claim 1 or 2 wherein the plurality of first photovoltaic sub-cells comprise a first active material and wherein the plurality of second photovoltaic sub-cells comprise a second active material different from the first active material.

4. The multi-junction photovoltaic module according any of the previous claims wherein the first photovoltaic sub-module and the second photovoltaic sub-module are stacked with their device side oriented towards each other.

5. A method for fabricating a multi-junction photovoltaic module, the method comprising:

- fabricating a first photovoltaic sub-module comprising a plurality of substantially identical first photovoltaic sub-cells that are monolithically integrated on a first substrate and which have a first active area size;
- connecting said plurality of substantially identical first photovoltaic sub-cells in series;
- fabricating a second photovoltaic sub-module comprising a plurality of substantially identical second photovoltaic sub-cells that are monolithically integrated on a second substrate and which have a second active area size which is different from the first active area size;
- connecting said plurality of substantially identical second photovoltaic sub-cells in series;
- stacking the second photovoltaic sub-module on the first photovoltaic sub-module
- electrically connecting said first and second photovoltaic sub-modules in parallel, thereby obtaining a photovoltaic module;
- determining the open circuit voltage $V_{C01}$ of the first photovoltaic sub-cells under illumination;
- determining the open circuit voltage $V_{C02}$ of the second photovoltaic sub-cells under illumination; and
- determining and providing the number N of first sub-cells in the first sub-module, and the number M of second sub-cells in the second sub-module that minimize the voltage mismatch between the first and second sub-modules, where N and M are integers.

6. A method according to claim 5, further comprising encapsulating the multi-junction photovoltaic module.

**Patentansprüche**

1. Photovoltaikmodul mit mehreren Anschlüssen, umfassend ein erstes photovoltaisches Untermodul und ein zweites photovoltaisches Untermodul, das auf das erste photovoltaische Untermodul gestapelt ist, wobei:

- das erste photovoltaische Untermodul eine Vielzahl von N ersten photovoltaischen Unterzellen umfasst, die monolithisch auf einem ersten Substrat integriert sind, und wobei das zweite photovoltaische Untermodul eine Vielzahl von M zweiten photovoltaischen Unterzellen umfasst, die monolithisch auf einem zweiten Substrat integriert sind, wobei N und M ganze Zahlen sind;
- die Vielzahl von N ersten photovoltaischen Unterzellen im Wesentlichen identisch ist und eine erste aktive Bereichsgröße aufweist;
- die Vielzahl von M zweiten photovoltaischen Unterzellen im Wesentlichen identisch ist und eine zweite aktive Bereichsgröße aufweist, die im Wesentlichen von der ersten aktiven Bereichsgröße verschieden ist;
- die Vielzahl von ersten photovoltaischen Unterzellen elektrisch in Serie geschaltet ist;
- die Vielzahl von zweiten photovoltaischen Unterzellen elektrisch in Serie geschaltet ist;
- das erste photovoltaische Untermodul und das zweite photovoltaische Untermodul elektrisch parallel geschaltet sind, wobei
- bei Beleuchtung alle N ersten photovoltaischen Unterzellen durch die gleiche Leerlaufspannung $V_{C01}$ gekennzeichnet sind, und alle M zweiten photovoltaischen Unterzellen durch die gleiche Leerlaufspannung $V_{C02}$ gekennzeichnet sind, und wobei
- bei Beleuchtung eine erste Photospannung, erzeugt vom ersten photovoltaischen Untermodul, im Wesentlichen genau so groß ist wie die zweite Photospannung , die vom zweiten photovoltaischen Untermodul erzeugt wird.

2. Photovoltaikmodul mit mehreren Anschlüssen nach Anspruch 1, wobei die ersten photovoltaischen Unterzellen und die zweiten photovoltaischen Unterzellen organische Unterzellen sind.

**3.** Photovoltaikmodul mit mehreren Anschlüssen nach Anspruch 1 oder 2, wobei die Vielzahl von ersten photovoltaischen Unterzellen ein erstes aktives Material umfasst, und wobei die Vielzahl von zweiten photovoltaischen Unterzellen ein zweites aktives Material umfasst, das sich vom ersten aktiven Material unterscheidet.

**4.** Photovoltaikmodul mit mehreren Anschlüssen nach einem der vorhergehenden Ansprüche, wobei das erste photovoltaische Untermodul und das zweite photovoltaische Untermodul mit ihrer Geräteseite zueinander ausgerichtet gestapelt sind.

**5.** Verfahren zur Herstellung eines Photovoltaikmoduls mit mehreren Anschlüssen, wobei das Verfahren Folgendes umfasst:

- Herstellung eines ersten photovoltaischen Untermoduls, umfassend eine Vielzahl von im Wesentlichen identischen ersten photovoltaischen Unterzellen, die monolithisch auf einem ersten Substrat integriert sind, und die eine erste aktive Bereichsgröße aufweisen;
- Verbindung der Vielzahl von den im Wesentlichen identischen ersten photovoltaischen Unterzellen in Serie;
- Herstellung eines zweiten photovoltaischen Untermoduls, umfassend eine Vielzahl von den im Wesentlichen identischen zweiten photovoltaischen Unterzellen, die monolithisch auf einem zweiten Substrat integriert sind, und die eine zweite aktive Bereichsgröße aufweisen, die von der ersten aktiven Bereichsgröße verschieden ist;
- Verbindung der Vielzahl von den im Wesentlichen identischen zweiten photovoltaischen Unterzellen in Serie;
- Stapelung des zweiten photovoltaischen Untermoduls auf dem ersten photovoltaischen Untermodul;
- elektrische Verbindung des ersten und des zweiten photovoltaischen Untermoduls parallel, wobei ein photovoltaisches Modul erhalten wird;
- Bestimmung der Leerlaufspannung $V_{C01}$ der ersten photovoltaischen Unterzellen bei Beleuchtung;
- Bestimmung der Leerlaufspannung $V_{C02}$ der zweiten photovoltaischen Unterzellen bei Beleuchtung; und
- Bestimmung und Bereitstellung der Anzahl N von ersten Unterzellen im ersten Untermodul und der Anzahl M der zweiten Unterzellen im zweiten Untermodul, die die Spannungsfehlanpassung zwischen dem ersten und dem zweiten Untermodul minimiert, wobei N und M ganze Zahlen sind.

**6.** Verfahren nach Anspruch 5, weiter umfassend die Einkapselung des photovoltaischen Moduls mit mehreren Anschlüssen.

**Revendications**

**1.** Module photovoltaïque à jonctions multiples comprenant un premier sous-module photovoltaïque et un deuxième sous-module photovoltaïque empilé sur le premier sous-module photovoltaïque, dans lequel :

- le premier sous-module photovoltaïque comprend une pluralité de N premières sous-cellules photovoltaïques qui sont intégrées de façon monolithique sur un premier substrat, et dans lequel le deuxième sous-module photovoltaïque comprend une pluralité de M deuxièmes sous-cellules photovoltaïques qui sont intégrées de façon monolithique sur un deuxième substrat, où N et M sont des nombres entiers ;
- la pluralité de N premières sous-cellules photovoltaïques est essentiellement identique, et présente une première taille de zone active ;
- la pluralité de M deuxièmes sous-cellules photovoltaïques est essentiellement identique, et présente une deuxième taille de zone active qui est essentiellement différente de la première taille de zone active ;
- la pluralité de premières sous-cellules photovoltaïques est connectée électriquement en série ;
- la pluralité de deuxièmes sous-cellules photovoltaïques est connectée électriquement en série ;
- le premier sous-module photovoltaïque et le deuxième sous-module photovoltaïque sont connectés électriquement en parallèle ; dans lequel
- sous éclairage, toutes les N premières sous-cellules photovoltaïques sont **caractérisées par** la même tension en circuit ouvert $V_{C01}$, et toutes les M deuxièmes sous-cellules photovoltaïques sont **caractérisées par** la même tension en circuit ouvert $V_{C02}$, et dans lequel
- sous éclairage, une première tension photoélectrique générée par le premier sous-module photovoltaïque est essentiellement égale à une deuxième tension photoélectrique générée par le deuxième sous-module photovoltaïque.

2. Module photovoltaïque à jonctions multiples selon la revendication 1, dans lequel les premières sous-cellules photovoltaïques et les deuxièmes sous-cellules photovoltaïques sont des sous-cellules organiques.

3. Module photovoltaïque à jonctions multiples selon la revendication 1 ou 2, dans lequel la pluralité de premières sous-cellules photovoltaïques comprend une première matière active et dans lequel la pluralité de deuxièmes sous-cellules photovoltaïques comprend une deuxième matière active différente de la première matière active.

4. Module photovoltaïque à jonctions multiples selon l'une quelconque des revendications précédentes, dans lequel le premier sous-module photovoltaïque et le deuxième sous-module photovoltaïque sont empilés avec leurs côtés de dispositif respectifs orientés l'un vers l'autre.

5. Procédé de fabrication d'un module photovoltaïque à jonctions multiples, le procédé comprenant :

   - la fabrication d'un premier sous-module photovoltaïque comprenant une pluralité de premières sous-cellules photovoltaïques essentiellement identiques qui sont intégrées de façon monolithique sur un premier substrat et qui présentent une première taille de zone active ;
   - la connexion de ladite pluralité de premières sous-cellules photovoltaïques essentiellement identiques en série ;
   - la fabrication d'un deuxième sous-module photovoltaïque comprenant une pluralité de deuxièmes sous-cellules photovoltaïques essentiellement identiques qui sont intégrées de façon monolithique sur un deuxième substrat et qui présentent une deuxième taille de zone active qui est différente de la première taille de zone active ;
   - la connexion de ladite pluralité de deuxièmes sous-cellules photovoltaïques essentiellement identiques en série ;
   - l'empilement du deuxième sous-module photovoltaïque sur le premier sous-module photovoltaïque ;
   - la connexion électrique desdits premier et deuxième sous-modules photovoltaïques en parallèle, en vue d'obtenir par conséquent un module photovoltaïque ;
   - la détermination de la tension en circuit ouvert $V_{C01}$ des premières sous-cellules photovoltaïques sous éclairage ;
   - la détermination de la tension en circuit ouvert $V_{C02}$ des deuxièmes sous-cellules photovoltaïques sous éclairage ; et
   - la détermination et la fourniture du nombre N de premières sous-cellules dans le premier sous-module et du nombre M de deuxièmes sous-cellules dans le deuxième sous-module, qui minimisent le décalage de tension entre les premier et deuxième sous-modules, où N et M sont des nombres entiers.

6. Procédé selon la revendication 5, comprenant en outre l'encapsulation du module photovoltaïque à jonctions multiples.

Fig.1(a)

Fig.1(b)

FIG. 1

FIG. 2

Fig.3(a)

Fig.3(b)

FIG. 3

Fig.4(a)

Fig.4(b)

Fig.5(a)

Fig.5(b)

FIG. 5

FIG. 6

FIG. 7

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 4784701 A
- US 20050217717 A
- US 4847669 A